# EUROPEAN PATENT APPLICATION

(11) **EP 0 597 525 A1**
(43) Date of publication of application: **18.05.1994**
(21) Application number: 93203074.5
(22) Date of filing: 03.11.1993
(51) Int. Cl.: H03G 3/34

(54) **Device for detecting pulsatory interference signals**

(30) Priority: 09.11.1992 EP 92203423
(71) Applicant: Philips Electronics N.V., 5621 BA Eindhoven (NL)
(72) Inventor: De Bijl, Mario Josephus, c/o Int. Octrooi. B.V., NL-5656 AA Eindhoven (NL); Sessink, Franciscus J.A.M., c/o Int. Octrooi. B.V., NL-5656 AA Eindhoven (NL)
(74) Representative: Schoonheijm, Harry Barend

(57) **Abstract**

Pulsatory interferences in a noise signal are detected by passing the signal mixture through a threshold circuit having a threshold value. To compensate for variations of the signal level, the signal mixture or the threshold value is controlled. The control will become considerably independent of the pulsatory interferences and will be substantially determined by the statistic distribution of the noise signal by subjecting the signal mixture to an amplitude comparison for generating the control signal.

## Description

The invention relates to a device for detecting pulsatory interference signals in a signal mixture substantially comprising noise signals, which device comprises a full-wave rectifier circuit having an input for receiving the signal mixture and an output for supplying a rectified signal mixture, and a threshold circuit having an input which is coupled to the output of the rectifier circuit for receiving the rectified signal mixture and an output for passing the pulsatory interference signals occurring in the rectified signal mixture and exceeding a threshold value.

Such a circuit for detecting pulsatory interference signals in a signal mixture comprising noise signals is known, inter alia from German Patent Specification 2 912 689 and is used, for example in FM car radio receivers having a circuit for suppressing the pulsatory interference signals (IAC = interference absorption circuit). In this circuit the received and demodulated multiplex signal is supplied via a restoration circuit which is blocked during the occurrence of an interference pulse and in which the interference pulse is replaced, for example by the signal level which is stored in a memory and occurs just before the occurrence of the interference pulse.

For detecting interference pulses in the received multiplex signal, use is made of the fact that the interference pulses have frequency components above the frequency band of the useful multiplex signal. For example, in FM stereo receivers the demodulated multiplex signal covers the frequency range up to approximately 60 kHz. By passing this signal through a high-pass filter having a cut-off frequency of approximately 60 kHz, the components of the useful multiplex signal are suppressed to a considerable extent. A signal mixture comprising the pulsatory interference signals and the noise above 60 kHz then remain.

In order to detect the pulsatory interference signals from the noise signals, the signal is first full-wave rectified so that all the positively directed and the negatively directed interference pulses acquire the same direction, and subsequently the signal is applied to a threshold circuit having such a threshold value that most interference pulses are passed and the noise signals are blocked. For an optimum interference pulse detection the threshold value should be just above the highest noise peaks so that these highest noise peaks are not detected or are substantially not detected as interference pulses, whereas even the noise pulses which are just above the noise are still detected as such.

However, the noise amplitude often varies considerably. For example, in FM radio reception the noise amplitude increases as the reception field strength decreases. To obtain a reliable detection of the pulsatory interference signals in the case of a varying noise amplitude, it is known, for example from the above-mentioned German Patent Specification 2 912 689, to pass the signal mixture through an amplitude control means before interference pulses are detected from this mixture so as to bring the signal mixture to a constant level in this way. To this end the output signal of the full-wave rectifier arranged downstream of the amplitude control means is applied to a peak value detector and the signal obtained by this peak value detection is applied as a control signal to the amplitude control means.

However, a drawback of the known circuit described above is that the control signal obtained by the peak value detection is considerably dependent on the mutual time intervals and values of the interference pulses present in the signal mixture, and the amplitude control of the signal is then incorrect. For example, if there are no interference pulses, the control signal generated by the peak value detector will be low, whereas the amplitude control means will have a large amplification and the higher noise peaks exceed the threshold value, which will lead to unwanted interference detection. On the other hand, after the occurrence of a strong interference pulse, the control signal obtained by means of the peak value detection will assume a high value for a given period. During this period the amplitude control means is then fed back to a strong extent so that the signal mixture occurring at the output of this control means will have a value which is too small with respect to the adjusted threshold value. As a result, possible weaker interference pulses which are present directly after the strong interference pulse will no longer be detected as such and will therefore not be suppressed.

It is an object of the invention to obviate this drawback in an effective manner and to this end the device according to the invention is characterized by an amplitude comparator having a comparator input which is adapted to receive the signal mixture and a comparator output for supplying a first and a second comparator output value, respectively, dependent on whether the signal mixture applied to the comparator input has an instantaneous signal value above or below a comparison value, and by a smoothing filter connected to the comparator output for supplying a control signal for controlling either said threshold value and said comparison value, or the signal mixture applied to the threshold circuit and the comparator input.

The invention is based on the recognition that, due to the function of the amplitude comparator, said control signal generated by the amplitude comparator and the smoothing filter and adjusting the mutual ratio between the threshold value and the signal mixture applied to the threshold circuit is substantially independent of the interference pulses present in the signal mixture and is substantially determined by the statistic distribution of the noise present in the signal mixture.

It is to be noted that it is not necessary for the comparator output to supply said first or second comparator output value at each value of the signal mixture at the comparator input. For example, if the comparator uses a limiter having a finite gain, values between said two output values will occur at the comparator output in the case of comparator input values which are close to the comparison value.

The first comparator output value may be positive and the second value may be equal to zero. The comparator output signal then has a positive mean value which is larger as the signal mixture applied to the comparator input is larger than the comparison value during a larger part of the period of time, while this positive mean value is used as a control signal after it has been smoothed by the smoothing filter. Generally, a large control gain and a reference level which is to be preset are required for the control by means of the control signal thus obtained. An embodiment of the invention which is more favourable in this respect is characterized in that the comparator supplies first and second comparator output values of mutually opposite polarity and in that the smoothing filter is an integrator. The control is then set automatically in such a way that the mean value of the comparator output signal is equal to zero, while the reference level setting is superfluous.

A further preferred embodiment is characterized in that the comparator receives the full-wave rectified signal mixture and supplies first and second comparator output values of opposite polarity and of equal value, and in that said threshold value is equal to approximately four times the comparison value. Due to the choice of equal, but opposite comparator output values it is achieved that the comparison value or the level of the signal mixture is set in such a way that the signal mixture is as often below the comparison value as it is above this value. If the threshold value is then chosen to be equal to approximately four times the comparison value, it is found that substantially no noise peaks and mainly interference pulse peaks exceed the threshold value.

The invention is not limited to interference suppression in car radio receivers, but may alternatively be useful for suppressing pulsatory interferences resulting from, for example scratches on gramo- phone records or magnetic tapes.

These and other aspects will be apparent from an elucidated with reference to the embodiments described hereinafter. In the drawings
Fig. 1 shows a circuit for suppressing pulsatory interferences, with a first embodiment of a device according to the invention,
Figs. 2 and 3 show curves to explain the operation of the circuit of Fig. 1 and
Fig. 4 shows a second embodiment of a device according to the invention.

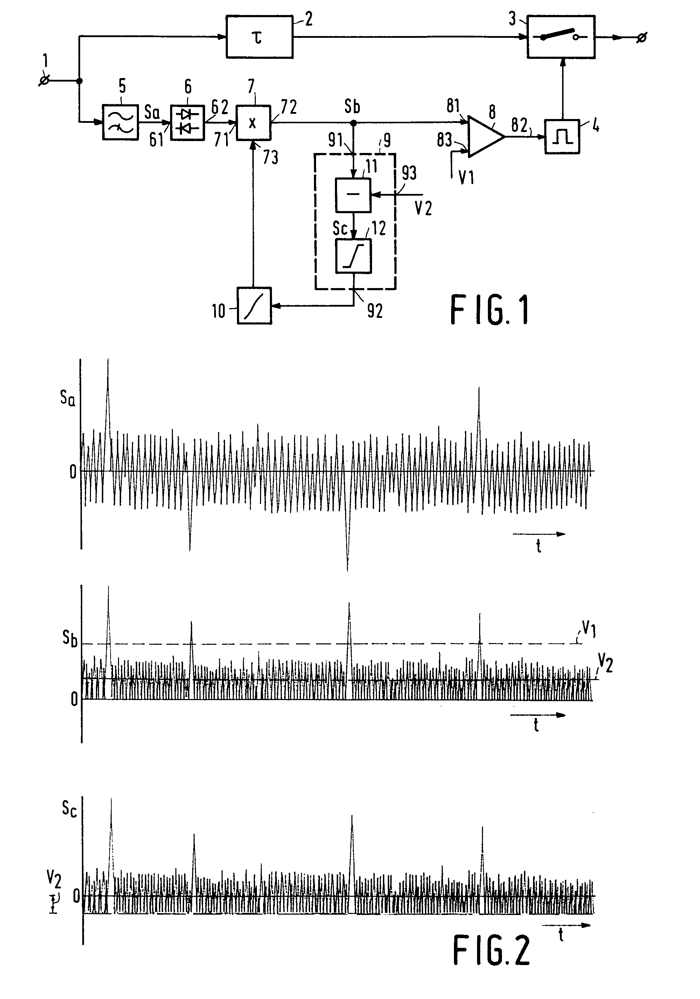

The circuit of Fig. 1 has an input terminal 1 to which an input signal Sᵢₙ is applied. If the circuit forms part of an FM car radio receiver, the input signal Sᵢₙ comprises, for example a stereo multiplex signal with a Left + Right sum signal in the frequency range up to 15 kHz, a pilot tone at 19 kHz and a Left - Right difference signal in the frequency range of 23-53 kHz.

The signal Sᵢₙ is applied via a delay circuit 2 to a restoration circuit 3 which is controlled by a pulse generator 4. The pulse generator supplies a switching pulse of a predetermined period to the restoration circuit when an interference pulse has been detected. When a switching pulse is received, the restoration circuit blocks the signal path so that the interference pulse is suppressed. The resultant interruption is replaced in known manner, for example by a constant signal level which is equal to the signal level just before the occurrence of the interference pulse or by a signal obtained by means of linear interpolation. The delay circuit 2 is necessary because the detection of the interference pulses and the generation of the switching pulses by the pulse generator 4 takes some time and to ensure that these pulses always arrive at the restoration circuit at a slightly earlier instant than the interference pulses.

For detecting the interference pulses, the input signal Sᵢₙ is applied to a high-pass filter 5 having a cut-off frequency of, for example 60 kHz. It is thereby achieved that the useful signal parts are attenuated to a considerable extent and that the interference pulse components above this cut-off frequency are passed on. The noise above the cut-off frequency is then also passed. The resultant signal mixture which mainly comprises noise with interference pulses exceeding the noise to a greater or lesser extent is shown by means of curve Sₐ in Fig. 2. In practice, the value of the noise may vary considerably and increases to a strong extent, for example when the reception field strength of the received FM signal decreases.

The signal mixture shown by means of curve Sₐ in Fig. 2 comprises positive and negative noise signals as well as positive and negative interference pulses. In order to detect both types of interference pulses in an equal way, the signal mixture is subsequently applied to an input 61 of a full-wave rectifier circuit 6. The rectifier signal mixture occurring at an output 62 of this rectifier circuit is shown by means of curve S_{b} in Fig. 2. This signal mixture is applied to an input 81 of a threshold circuit 8 via an amplitude control means 7 having a signal input 71, a signal output 72 and a control input 73. The function of the amplitude control means 7 will hereinafter be described in greater detail. The threshold circuit 8 only passes those signal peaks to an output 82 which exceed a threshold value V₁ applied to an input 83. The interference pulse peaks at the output 82 are applied to the pulse generator 4 where they generate the switching pulses for the restoration circuit 3.

In Fig. 2 the curve S_{b} shows the signal mixture at the input 81 of the threshold circuit, while a horizontal broken line V₁ represents the optimum threshold value, i.e. the threshold value which is just above the noise signal so that the noise signal cannot "trigger" the pulse generator 4, while substantially all interference pulses exceeding the noise signals are capable of "triggering" the pulse generator.

For generating the control signal to be applied to the control input 73 of the amplitude control means 7, the circuit of Fig. 1 includes an amplitude comparator 9 having a comparator input 91 connected to the output 72 of the amplitude control means 7 and an output 92 which is connected to the control input 73 of the amplitude control means via an integrator 10. A comparison value V₂ is applied to a second input 93 of the comparator 9. The amplitude comparator 9 comprises a subtracter circuit 11 which subtracts an amount having the value of the comparison value V₂ from the signal mixture applied via the input 91. The comparator 9 also comprises a symmetrical limiter 12 having a sufficiently high gain and being connected to the output of the subtracter circuit 11. The limiter 12 preferably has an infinite gain and is implemented with a Schmitt trigger without hysteresis. The limiter 12 supplies the output signal of the comparator 9 at its output 92.

The curve S_{c} in Fig. 2 represents the signal mixture at the input of the limiter 12. This is the same signal as is shown by means of the curve S_{b} but, due to the operation of the subtracter circuit 11, with the comparison value V₂ being lowered. This implies that, with the signal mixture at the comparator input 91 being always positive due to the full-wave rectification, the signal mixture S_{c} is partly negative and partly positive, viz. negative when the instantaneous value of the signal mixture S_{b} is smaller than the comparison value V₂ and positive when the instantaneous value of the signal mixture S_{b} is larger than the comparison value V₂.

The symmetrical limiter 12 supplies a constant positive signal (+1) at the comparator output 92 when the signal mixture S_{c} is positive and a signal of the same value and opposite sign (-1) when the signal mixture S_{c} is negative. This implies that the comparator output supplies a first comparator output value + 1 when the instantaneous value of S_{b}, is larger than V₂ and a second comparator output value - 1 when the instantaneous value of S_{b} is smaller than V₂.

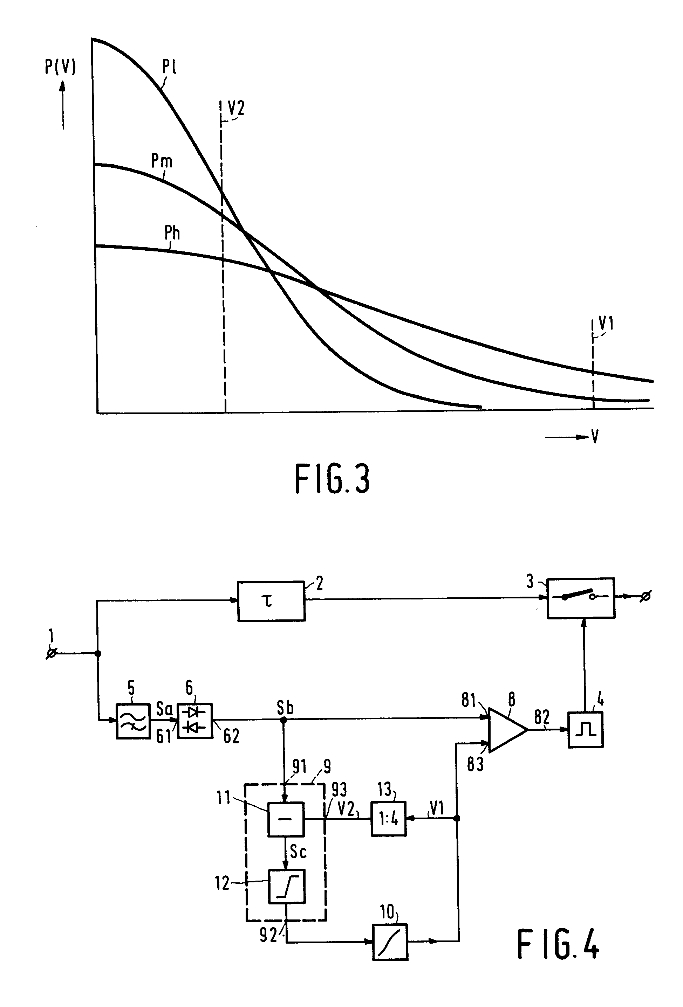

To elucidate the operation of the amplitude control means 7, the amplitude comparator 9 and the integrator 10, reference is made to Fig. 3. The curves p,, pₘ and pₕ in this Figure show by way of example the statistic value distribution of the rectified signal mixture at the output 62 of the full-wave rectifier 6 for three different signal levels, with the signal value V being plotted horizontally and the statistic distribution p(V) being plotted vertically. In the diagram p(V)^{*}dV represents the probability of the signal being between the values of V and V+dV. The integral of p(V)^{*}dV of all values of V, represented by the total surface area under the p-(V) curve, is of course equal to 1. Vertical broken lines denote the adjusted threshold value V₁ and the adjusted comparison value V₂. It is to be noted that Fig. 3 shows the normal Gauss distribution of a rectified noise signal, but this is not essential and the invention is also applicable in the case of deviating distributions of the noise signal.

If the signal mixture has a low level, the statistic distribution of, for example, the curve p, applies. Then there are more moments in the signal mixture S_{b} at which the instantaneous signal value is smaller than V₂ than where this value is larger than V₂. In fact, the surface area located under the curve p, to the left of the broken line V₂ is larger than the surface area under this curve to the right of the line V₂. The comparator output signal is thus more frequently negative than positive. This signal is integrated in the integrator 10 and the integrator 10 thus applies a decreasing control signal to the amplitude control means 7 so that the gain of this control means increases. This implies that the statistic distribution curve of the signal mixture S_{b}, shifts from the curve p, towards the curve pₘ.

If, on the other hand, the signal mixture S_{b}, has a high level, the statistic distribution of, for example curve pₕ applies. The surface area under the pₕ, curve to the right of the line V₂ is, however, larger than that to the left of this line. The instantaneous value of the signal mixture S_{b}, is thus more frequently larger than V₂ than where this value is smaller than V₂ and the comparator output signal is thus more frequently positive than negative, while the integrator 10 applies an increasing control signal to the amplitude control means 7. Consequently, the gain of the control means decreases and the statistic distribution curve of the signal mixture S_{b} shifts from the curve pₕ towards the curve pₘ. The control means is eventually set in such a way that the signal mixture S_{b}, is as frequently smaller than the comparison value V₂ as it is larger than this value. The output signal of the amplitude comparator 9 is then equal to 0 on average and the output signal of the integrator 10 is constant. This is the case for the statistic distribution curve pₘ.

The extreme right portion of the statistic distribution curve represents the interference pulses which are larger than the noise peaks but occur less frequently than the noise peaks. Fig. 3 shows a possible threshold value for the threshold circuit 8 by means of the second vertical broken line Vᵢ. The threshold value V₁ is chosen to be such that with the statistic distribution pₘ the interference pulses are substantially larger and the noise peaks are substantially smaller than the threshold value V, . In practice this is usually the case at a threshold value V₁ which is approximately four times as large as the comparison value V₂. It is also apparent from Fig. 3 that no or too few interference pulses are detected at too low levels of the signal mixture (curve p) and that a large number of noise peaks is detected as interference pulses at too high levels of the signal mixture (curve pₕ) when the amplitude control means 7 is not correctly controlled (which is notably the case if the control is effected from a peak value detector).

Fig. 1 shows the threshold value V₁ and the comparison value V₂ as values to be externally applied to the threshold value and the comparator, respectively. These values may of course also be supplied internally, for example by means of zener voltages or forward voltages of bipolar diodes, or by means of values represented by binary numbers.

The comparator which comprises a subtracter circuit 11 and a symmetrical limiter 12, as shown in Fig. 1, may alternatively be realised in a different manner, for example by means of a symmetrically limiting differential amplifier having two inputs, one for the signal mixture S_{b} and one for the comparison value V₂. Neither is it necessary for the comparator to supply symmetrical output values. If the comparator supplies, for example a negative output value when S_{b} < V₂ and a twice larger positive output value when S_{b} > V₂, the level of the signal mixture will be controlled in such a way that the surface area below the associated pₘ curve to the right of V₂ is equal to half the surface area below this pₘ curve to the left of V₂.

Instead of the full-wave rectified signal mixture, a half-wave rectified signal mixture or a non-rectified signal mixture may be applied to the input 91 of the comparator 9. However, it is then necessary that the comparator supplies asymmetrical comparator output values, for example -1 when the signal mixture at the comparator input is smaller than the comparison value V₂ and +3 when this signal mixture is larger than V₂.

Instead of the integrator 10, a different type of smoothing filter may be chosen, for example a low-pass filter in which generally a mean value, different from zero, of the comparator output signal occurs at the output of the low-pass filter. This value is compared in a manner not further shown with a setting value and the difference is amplified and subsequently applied as a control signal to the input 73 of the control means 7.

The full-wave rectifier 6 may be arranged in the output signal lead of the control means 7 instead of in the input signal lead of this control means, as is shown in Fig. 1.

Fig. 4 shows a further modification of the circuit of Fig. 1 in which corresponding elements have the same reference numerals as those in Fig. 1. In this modification the control means 7 has been omitted. The signal mixture S_{b}, varying in level and originating from the full-wave rectifier 6 is applied in an uncontrolled form to the input 81 of the threshold circuit 8. The output of the integrator 10 is coupled to the second input 82 of the threshold circuit 8 and thus supplies the threshold value V1. The circuit further comprises an attenuator 13 which is arranged between the integrator output and the input 93 of the comparator 9. The attenuator attenuates by a factor of approximately 4 so that the comparison value V₂ is approximately one fourth of the threshold value Vᵢ. In this modification the signal mixture S_{b} varies, hence the statistic distribution of, for example the curve p, also varies via pₘ to pₕ. The control circuit comprising the comparator 9, the integrator 10 and the attenuator 13 ensures that the comparison value V₂ varies proportionally with the level of the signal mixture so that the V₂ line always divides the surface area under the p curve into two equal parts. The threshold value V₁ also varies proportionally with the varying signal mixture level (in fact, V₁ = 4^{*}V₂) so that only interference pulses exceeding the noise signal are passed by the threshold circuit 8. In this modification it should be taken into account that the pulse generator 4 should be suitable for receiving interference pulses which vary to a stronger extent than those in the circuit of Fig. 1. Instead of the factor 4 attenuator 13 for the comparison value V₂, a factor 4 attenuator upstream of the S_{b} input 81 of the threshold circuit 8 or a factor 4 amplifier upstream of the V₁ input 83 of this threshold circuit may be used.

It is to be noted that all components of the described embodiments of the present invention can be implemented by means of known techniques in both analog and digital form, and in certain cases by means of software-controlled digital signal processors.

## Claims

1. A device for detecting pulsatory interference signals in a signal mixture (Sₐ) substantially comprising noise signals, which device comprises a full-wave rectifier circuit (6) having an input (61) for receiving the signal mixture (Sₐ) and an output (62) for supplying a rectified signal mixture (S_{b}), and a threshold circuit (8) having an input (81) which is coupled to the output of the rectifier circuit for receiving the rectified signal mixture (S_{b}) and an output (82) for passing the pulsatory interference signals occurring in the rectified signal mixture and exceeding a threshold value (Vi), characterized by an amplitude comparator (9) having a comparator input (91) which is adapted to receive the signal mixture (Sₐ, S_{b}) and a comparator output (92) for supplying a first and a second comparator output value, respectively, dependent on whether the signal mixture applied to the comparator input (91) has an instantaneous signal value above or below a comparison value (V₂), and by a smoothing filter (10) connected to the comparator output (92) for supplying a control signal for controlling either said threshold value (Vi) and said comparison value (V₂), or the signal mixture applied to the threshold circuit (8) and the comparator input (91).

2. A device as claimed in Claim 1, characterized in that the comparator (9) supplies first and second comparator output values of mutually opposite polarity and in that the smoothing filter (10) is an integrator.

3. A device as claimed in Claim 2, characterized in that the comparator (9) receives the full-wave rectified signal mixture (S_{b}) and supplies first and second comparator output values of opposite polarity and of equal value, and in that said threshold value (Vi) is equal to approximately four times the comparison value (V₂).
